# EUROPÄISCHE PATENTSCHRIFT

(11) **EP 2 759 715 B1**
(45) Veröffentlichungstag und Bekanntmachung des Hinweises auf die Patenterteilung: **08.05.2019**
(21) Anmeldenummer: 14000181.9
(22) Anmeldetag: 17.01.2014
(51) Int. Cl.: F15B 15/28, G01D 5/165

(54) **Verfahren zur Bestimmung der Kolbenposition einer Kolbenzylindereinheit und Kolbenzylindereinheit**
Method for determining the piston position in a piston-cylinder unit and piston-cylinder unit
Procédé de détermination de la position du piston d'un vérin et ensemble comportant un tel vérin

(30) Priorität: 23.01.2013 DE 102013001121
(43) Veröffentlichungstag der Anmeldung: 30.07.2014
(73) Patentinhaber: Liebherr-Elektronik GmbH, 88131 Lindau (DE)
(72) Erfinder: Braun, Sebastian, 88131 Lindau (DE); Engler, Alfred, 88138 Sigmarszell (DE); Cremer, Ralf, 88131 Lindau (DE); Nannen, Ingo, 88161 Lindenberg (DE)
(74) Vertreter: Laufhütte, Dieter

(56) Entgegenhaltungen:
- EP-A2- 2 149 715
- DE-A1-102007 046 139
- DE-A1-102011 008 381
- FR-A1- 2 950 401
- US-A- 5 886 617

## Beschreibung

Die Erfindung betrifft ein Verfahren zur Bestimmung der Kolbenposition einer hydraulischen oder pneumatischen Kolbenzylindereinheit sowie eine Kolbenzylindereinheit mit einer Vorrichtung zur Positionsbestimmung.

Eine möglichst exakte Positionsbestimmung eines Zylinderkolbens wird für eine Reihe technischer Anwendungen vorausgesetzt. Insbesondere wird für die automatisierte Ansteuerung einer Kolbenzylindereinheit die exakte Kolbenposition als Regelgröße benötigt. Zudem kann die Positionsbestimmung zur Erhöhung der Betriebssicherheit beitragen, da der Einlass des Hydraulikmediums, insbesondere der Hydraulikflüssigkeit, in Extrempositionen des Zylinderkolbens exakt gesteuert und folglich rechtzeitig gestoppt werden kann.

Vor allem ist eine präzise Positionsbestimmung bei der automatischen Ansteuerung der Kolbenzylindereinheit bei Baumaschinen bzw. Hubgeräten von Bedeutung. Die Kolbenzylindereinheit betätigt in üblicher Weise das Arbeitsgerät der Baumaschine bzw. des Hubgerätes. Eine hinreichend genaue Positionsbestimmung der Kolbenzylindereinheit erhöht die Qualität der Ansteuerung und ist daher dringend erforderlich.

Bisher ist es bekannt, die aktuelle Position des Zylinderkolbens durch angeordnete Seilzugpotentiometer zu erfassen.

Ein alternatives Verfahren zur Längenausdehnungsmessung der Hydraulikzylinder arbeitet nach einem magnetostriktiven Prinzip. Jedoch muss für die Integration des Messelementes in den Zylinder die Kolbenstange axial gebohrt werden. Gerade bei sehr langen Zylindern ist dies eine sehr kostspielige Angelegenheit, die viel Aufwand hinsichtlich der Tiefbohrtechnik erfordert. Ebenso stellt die benötigte Kabelführung der verwendeten Messelektronik innerhalb des Zylinders eine herausfordernde Aufgabe dar.

Aus der DE 10 2005 029 494 A1 ist ein weiteres Verfahren zur Positionsbestimmung von Hydraulik- und Pneumatikzylindern bekannt. Die daraus hervorgehende Kolbenzylinderanordnung weist ein Sensorelement auf, das mit einem magnetischen Geberelement in Wechselwirkung steht. Der Kolben übernimmt die Funktion eines Tauchkerns (Geberelement), dessen Position über eine Wegsensorspule (Sensorelement) erfasst und durch eine Auswerteelektronik bestimmt wird. Die Wegsensorspule befindet sich in der kolbenstangenabgewandten Seite des Zylinderrohrs.

Ein weiteres Messprinzip ist aus der DE 10 2011008 381 bekannt. Das darin angewandte Resonanzmessverfahren bestimmt auf Grundlage der gebildeten Kapazität und der Induktivität der Kolbenzylinderanordnung die aktuelle Position des Kolbens. Als längenveränderliche Variable ist im Wesentlichen die gemessene Induktivität ausschlaggebend. Nachteilig an dem genannten Messverfahren ist jedoch, dass sporadisch auftretende Kurzschlusseffekte zwischen Kolben und Mantelfläche, beispielsweise durch Verunreinigungen innerhalb der Kolbenzylindereinheit, die Messgenauigkeit verfälschen können. Damit besteht ein Restrisiko beim Betrieb derartiger Zylindereinheiten.

In der FR 2 950 401 A1 ist ein weiteres Messprinzip offenbart, bei dem die aktuelle Kolbenposition über den elektrischen Widerstand eines von Zylindermantel, Zylinderkolben und Zylinderstange gebildeten elektrischen Leitungsweges bestimmt wird. Dabei hängt lediglich die Länge des Leitungsweges des Zylindermantels von der Kolbenposition ab. Der Referenz-Widerstand des Zylinderrohrs wird über vier Leitungen gemessen. Gleichzeitig ist der Zylinderkolben elektrisch an das Zylinderrohr angeschlossen und bildet mit diesem einen Widerstandsteiler. Über eine an der Zylinderstange angeschlossene fünfte Leitung wird der Widerstandsteiler vermessen und daraus die aktuelle Kolbenposition bestimmt. Nachteilig an dieser Lösung ist, dass das Zylinderrohr extern vermessen werden muss und die Kolbenpositionsbestimmung mittels eines vergleichsweise komplizierten 5-Draht-Messprinzips erfolgt.

Ein ähnliches, auf einem 3-Draht-Messprinzip beruhendes, Verfahren sowie eine entsprechende Vorrichtung ist aus der DE 10 2007 046 139 A1 bekannt, wobei auch hier eine Referenzmessung des Zylinderrohrwiderstandes durchgeführt wird.

Ziel der vorliegenden Erfindung ist es daher, dem Fachmann ein alternatives und sicheres Messverfahren zur Positionsbestimmung des Kolbens innerhalb einer Kolbenzylindereinheit an die Hand zu geben.

Diese Aufgabe wird durch ein Verfahren gemäß den Merkmalen des Anspruchs 1 gelöst. Vorteilhafte Ausführungsformen sind Gegenstand der abhängigen Ansprüche.

Gemäß Anspruch 1 wird ein Verfahren zur Bestimmung der Kolbenposition einer hydraulischen oder pneumatischen Kolbenzylindereinheit vorgeschlagen. Erfindungsgemäß bilden zumindest Teile des Zylindermantels und des Zylinderkolbens einen elektrischen Leitungsweg, wobei der Zylinderkolben sowie der Zylindermantel leitend miteinander verbunden und die Kolbenstange und Zylindermantel gegeneinander isoliert sind. Folglich bilden Kolbenstange, Zylinderkolben sowie Zylindermantel einen leitend miteinander verbundenen Leitungsweg. Anhand der induktiven und/oder ohmschen Eigenschaften des gebildeten Leitungswegs lässt sich die aktuelle Kolbenposition hinreichend exakt bestimmen.

Die Erfindung macht sich die Tatsache zunutze, dass die Kolbenposition die Charakteristik des elektrischen Leitungswegs beeinflusst. Insbesondere wird die Leitungslänge durch die Kolbenposition variiert, wobei sowohl der Leitungsweg des Zylindermantels als auch der Leitungsweg der Kolbenstange von der Kolbenposition abhängt. Mit Hilfe geeigneter Auswerteverfahren können die induktiven und/oder ohmschen Eigenschaften des elektrischen Leitungswegs erfasst werden. Die ermittelten Werte lassen einen Rückschluss auf die tatsächliche exakte Kolbenposition zu.

Die Leitungscharakteristika können vorzugsweise auf Grundlage eines auf Wechselspannung und/oder Gleichspannung basierenden Auswerteverfahrens bestimmt werden. Hierzu wird der gebildete Leitungsweg entweder mit einem Gleichspannungs- oder mit einem Wechselspannungssignal angeregt und das induktive bzw. ohmsche Verhalten mittels geeignetem Auswerteverfahren bestimmt.

Bei einer Auswertung der Leitungscharakteristika auf Grundlage von Gleichspannungs- bzw. Wechselspannungssignalen besteht der Vorteil darin, dass dieses unabhängig von dem in der Zylinderkammer vorhandenen Medium, beispielsweise Luft oder Hydraulikmedium, ausführbar ist. Dadurch haben Ölalterung, Verschmutzung und eventuelle Temperatureinflüsse keinen bzw. nur äußerst geringen Einfluss auf die Messgrößen.

Im Falle eines auf Wechselspannung basierenden Auswerteverfahrens ist es zweckmäßig, die Frequenz der anregenden Wechselspannung vorzugsweise variabel auszugestalten, um einen reibungslosen Betrieb mehrerer Kolbenzylindereinheiten an der jeweiligen Anwendung (z. B. Bagger) zu gewährleisten. Bei geeigneter Frequenzwahl im niederfrequenten Bereich, kann auf eine Abschirmung verzichtet werden.

Die Art des Auswerteverfahrens zur Bestimmung der Leitungscharakteristika ist im Grunde beliebig. Als geeignete Auswerteverfahren erweisen sich die Messung der externen Resonanz der Kolbenzylindereinheit bzw. die Messung einer Impulsantwort als zweckmäßig. Mit der Begrifflichkeit externe Resonanz ist die zu erfassende positionsabhängige Resonanzfrequenz der Kolbenzylindereinheit gemeint, die durch das in Serie schalten eines Kondensators zur Kolbenzylindereinheit entsteht. Ebenfalls ist es denkbar, mittels einer Messbrücke den ohmschen Widerstand der gebildeten Leitungslänge zu messen.

Das vorgeschlagene Verfahren hat den Vorteil, dass dieses mit besonders geringem Integrationsaufwand für beliebige Zylinder einsetzbar ist. Gegenüber bekannten Verfahren zeichnet sich der erfindungsgemäße Lösungsansatz durch vergleichsweise geringe Produktions- bzw. Integrationskosten aus. Zudem unterliegt das erfindungsgemäße Verfahren keinen Baugrößenbeschränkungen der Kolbenzylindereinheiten. Das vorgeschlagene Verfahren lässt sich daher in nahezu jedem Arbeitszylinder implementieren.

Die Erfindung betrifft zudem eine Kolbenzylindereinheit mit einer Vorrichtung zur Positionsbestimmung gemäß den Merkmalen des Anspruchs 4.

Die Kolbenzylindereinheit ist zur Durchführung des erfindungsgemäßen Verfahrens bzw. einer vorteilhaften Ausgestaltung des erfindungsgemäßen Verfahrens geeignet. Es ist dabei offensichtlich, dass die Kolbenzylindereinheit entsprechende Mittel zur Ausführung des Verfahrens aufweisen muss. Die Vorteile und Eigenschaften dieser Kolbenzylindereinheit entsprechen offensichtlichen denen, des erfindungsgemäßen Verfahrens bzw. einer vorteilhaften Ausgestaltung des Verfahrens.

Sinnvollerweise wird die vorhandene Kolbenstangendichtung als Isolierung der Kolbenstange gegenüber dem Zylindermantel genutzt.

Zur Herstellung einer leitenden Verbindung zwischen Kolben und Zylindermantel kann vorzugsweise wenigstens ein elektrisch leitender Kolbenring vorgesehen sein, der vollständig um den Kolbenumfang verläuft. Denkbar ist ebenso eine nur partielle Kontaktierung zwischen Kolben und Zylindermantelfläche.

Alternativ lassen sich auch ein oder mehrere Schleifkontakte am Kolbenumfang bzw. an der Kolbenfläche befestigen, die eine elektrisch leitende Verbindung zwischen Kolben und Zylindermantel herstellen.

Die Auswerteeinheit ist mittelbar oder unmittelbar mit dem Kolben sowie mittelbar oder unmittelbar mit dem Zylindermantel elektrisch leitend verbunden. Durch Veränderung der Kolbenposition verändert sich der elektrische Leitungsweg zwischen den Anschlüssen der Auswerteeinheit. Die Auswerteeinheit ist im Bereich der Kolbenstangenführung des Zylindermantels angeschlossen, so dass sich der gebildete elektrische Leitungsweg vergrößert, sobald der Kolben in den Zylindermantel eingefahren wird. Die minimale Leitungslänge liegt vor, sobald die Kolbenstange vollständig aus dem Zylindermantel ausgefahren ist. Der Kolbenhub bestimmt die minimale bzw. maximale Leitungslänge.

Selbstverständlich kann die Auswerteeinheit auch mit der gegenüberliegenden Stirnfläche des Zylindermantels verbunden werden. Die Leitungscharakteristika verhalten sich dann entgegengesetzt.

Die Auswerteeinheit weist vorzugsweise Mittel zur Durchführung eines auf Wechselspannung bzw. Gleichspannung basierenden Auswerteverfahrens auf. Insbesondere umfasst die Auswerteeinheit ein oder mehrere Signalgeneratoren zur Erzeugung und Einspeisung eines Wechselspannungs- bzw. Gleichspannungssignals in den gebildeten Leitungsweg.

Die Auswertung der induktiven und/oder ohmschen Eigenschaften des gebildeten Leitungsweges kann auf Grundlage unterschiedlicher Auswerteverfahren erfolgen. Denkbar ist beispielsweise die Messung der externen Resonanz der Kolbenzylindereinheit oder auch die Auswertung einer Impulsantwort. Möglich ist es auch, dass die Auswerteeinheit eine Messbrücke aufweist, mit der sich der ohmsche Widerstand der angeschlossenen Leitungslänge ermitteln lässt.

Die Erfindung betrifft des Weiteren eine Baumaschine oder ein Hubgerät mit einer Kolbenzylindereinheit gemäß der vorliegenden Erfindung bzw. einer vorteilhaften Ausgestaltung der Erfindung. Die Vorteile und Eigenschaften der Baumaschine bzw. des Hubgeräts entsprechend offensichtlich denen des erfindungsgemäßen Verfahrens bzw. der erfindungsgemäßen Kolbenzylindereinheit, weshalb an dieser Stelle auf eine wiederholende Beschreibung verzichtet wird.

Weitere Vorteile und Eigenschaften der Erfindung sollen im Folgenden anhand einiger Ausführungsbeispiele näher erläutert werden. Es zeigen:
- Figur 1:: eine schematische Längsschnittdarstellung eines ersten Ausführungsbeispiels der Kolbenzylindereinheit, welches jedoch nicht Teil der vorliegenden Erfindung ist,
- Figur 2:: eine schematische Längsschnittdarstellung eines Ausführungsbeispiels der erfindungsgemäßen Kolbenzylindereinheit,
- Figur 3:: eine schematische Längsschnittdarstellung eines zweiten Ausführungsbeispiels der erfindungsgemäßen Kolbenzylindereinheit und
- Figur 4:: Ersatzschaltbilder zur Charakterisierung des gebildeten elektrischen Leitungswegs der erfindungsgemäßen Kolbenzylindereinheit.

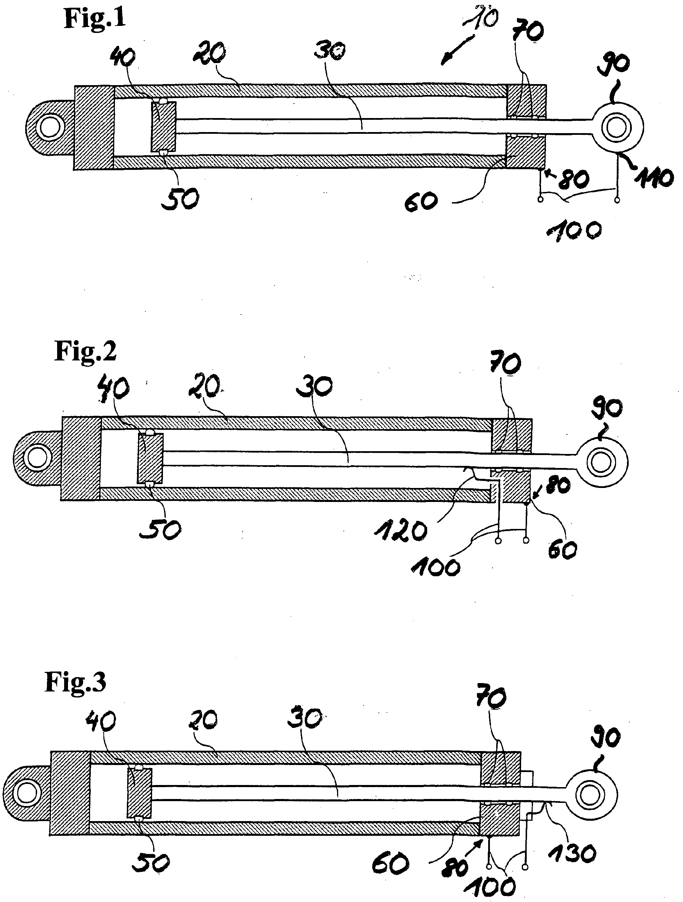

Die Figuren 1 bis 3 zeigen unterschiedliche Beispiele einer Kolbenzylindereinheit 10 mit einer Vorrichtung zur Positionsbestimmung. Der Aufbau der Kolbenzylindereinheit 10 ähnelt einer bekannter Kolbenzylindereinheit. Im Einzelnen umfasst die Einheit 10 einen rohrförmigen Zylindermantel 20, in dessen Hohlraum ein Kolben 40 mit angeordneter Kolbenstange 30 linear verschiebbar gelagert ist.

Die Kolbenzylindereinheit 10 wird bevorzugt bei Baumaschinen bzw. Hubgeräten eingesetzt, wobei beispielsweise ein befestigtes Arbeitsgerät durch die Kolbenzylindereinheit 10 angetrieben wird. Der Automatikbetrieb des Arbeitsgerätes erfordert die präzise Positionsbestimmung des Kolbens 40.

Um eine exakte Positionsbestimmung zu ermöglichen, müssen weder zusätzliche Sensoren, Elektroden oder Messwertgeber an oder in der Kolbenzylindereinheit installiert werden. Stattdessen wird die Tatsache ausgenützt, dass sich die ohmschen bzw. induktiven Eigenschaften der Kolbenzylindereinheit 10 in Abhängigkeit der Kolbenstellung verändern. Um die rein induktiven und/oder ohmschen Eigenschaften des Zylinders 10 auswerten zu können, muss eine leitende Verbindung zwischen dem Kolben 40 und dem Zylindermantel 20 bzw. der Innenwandung des Zylindermantels 20 hergestellt werden. Der elektrische Kontakt wird durch einen koaxial auf dem Kolbenumfang 40 angeordneten Kolbenring 50 ermöglicht, der sich durch eine hinreichende Leitfähigkeit auszeichnet. Die Dichtung zwischen Zylindermantel 20 und Kolben 40 wird durch den Kolbenring 50 nicht beeinflusst.

Anstelle des elektrisch leitenden Kolbenrings 50 können alternativ ein oder mehrere Schleifkontakte am Kolben 40, insbesondere an den Kolbenflächen angeordnet sein, die eine elektrische Verbindung zwischen Zylindermantel 20 und Kolben 40 herstellen.

Weiterhin muss die Kolbenstange 30 gegenüber dem Zylindermantel 20 isoliert sein. Hierfür wird die ohnehin vorhandene Zylinderdichtung 70 in der Kolbenstangenführung genutzt, die eine isolierende Wirkung zwischen Kolbenstangenführung und Kolbenstange 30 entfaltet.

Eine nicht dargestellte Auswerteeinheit wird über die beiden Anschlusspole 100 mit der Kolbenzylindereinheit 10 elektrisch leitend verbunden. Die Kontaktierung mit der Zylindermantelfläche 20 erfolgt im Bereich des Zylinderkopfes 60 im Kontaktpunkt 80. Die Kontaktierung mit der Kolbenstange 30 kann demgegenüber variabel gewählt werden.

In einem ersten Ausführungsbeispiel gemäß Figur 1, welches jedoch nicht Teil der vorliegenden Erfindung ist, wird die Auswerteeinheit neben dem Kontaktpunkt 80 über den Kontaktpunkt 110 direkt mit dem Kolbenauge 90 fest verbunden. Demgegenüber wird im Ausführungsbeispiel der Figur 2 eine gleitende Verbindung der Auswerteeinheit mit der Kolbenstange 30 gewählt, wobei diese mit Hilfe eines Schleifkontaktes 120 im Inneren des Kolbenmantels 20 bereitgestellt wird. Genauso kann der Schleifkontakt zwischen Auswerteeinheit und Kolbenstange 30 auch außerhalb der Zylindermantelfläche liegen, wie dies durch den Schleifkontakt 130 des Ausführungsbeispiels der Figur 3 realisiert ist.

Die Auswahl der Anschlussart der Auswerteeinheit mit der Kolbenstange 30 ist beliebig und hat keinen Einfluss auf die Messgenauigkeit. Jedoch muss bei der Auswertung die Anschlussart Berücksichtigung finden, um die exakte Kolbenposition bestimmen zu können. Zu beachten ist hierbei, dass im Ausführungsbeispiel der Figur 1 der resultierende Leitungsweg zwischen den Anschlusspolen 100 der Auswerteeinheit durch die gesamte Länge der Kolbenstange 30, dem Verbindungsweg zwischen Kolbenstange 30 und Zylindermantel 20 über den Kolben 40 sowie der variablen Mantelstrecke des Zylindermantels 20 ausgehend von der aktuellen Kolbenposition bis hin zum Kontaktpunkt 80 im Bereich des Zylinderkopfes 60 definiert wird. Dieser variable Leitungsweg wird durch ein Ausfahren der Kolbenstange 30 verringert und erreicht sein Minimum bei vollständig ausgefahrener Kolbenstange 30. Der maximale Leitungsweg stellt sich ein, sobald die Kolbenstange 30 vollständig in den Zylinderraum der Kolbenzylindereinheit 10 eingefahren ist.

In den Ausführungsbeispielen der Figuren 2 und 3 ist die Kontaktierung der Auswerteeinheit mit der Kolbenstange 30 mittels der Schleifkontakte 120 sowie 130 realisiert. Demnach variiert nicht nur der Leitungsweg der Zylindermantelfläche 20 vom Kolben 40 bis hin zum Zylinderkopf 60 sondern auch der Leitungsweg zwischen Schleifkontakt 120, 130 und Kolben 40. Für die Änderung des anliegenden Leitungsweges zwischen den Anschlusspolen 100 gelten die Ausführungen bezüglich Figur 1.

Das vorgeschlagene mechanische Konzept, d.h. die ständige Kurzschlussbildung zwischen Kolben 40 und Zylindermantel 20, verwirklicht ein elektrisches Netzwerk mit kolbenpositionsabhängigen induktiven und/oder ohmschen Eigenschaften.

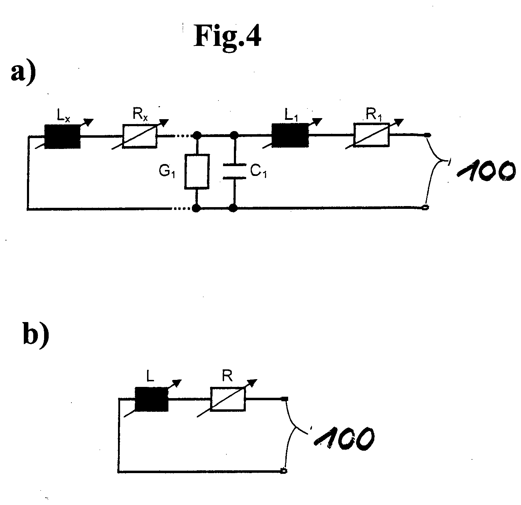

Die Auswertung dieser induktiven und ohmschen Variablen kann sowohl durch ein auf Wechselspannung als auch auf Gleichspannung basierendes Auswerteverfahren erfolgen. Für ein auf Gleichspannung basierendes Auswerteverfahren oder ein auf Wechselspannung mit niedriger Frequenz basierendes Auswerteverfahren gilt das Ersatzschaltbild der Figur 4b. Die Eigenschaften der gebildeten Leitung zwischen den Anschlusspolen 100 der Auswerteeinheit lassen sich grob über den ohmschen Widerstand R sowie deren Induktivität L beschreiben. Beide Größen sind abhängig von der Leitungslänge bzw. der Position des Kolbens 40.

Die Auswerteeinheit kann beispielsweise als Messbrücke ausgeführt sein, die mit den Anschlusspolen 100 verbunden wird und den ohmschen Widerstand R der angeschlossenen Kolbenzylindereinheit 10 in Abhängigkeit der Kolbenposition bestimmt. Den kleinsten ohmschen Widerstand nimmt das System ein, sobald die Kolbenstange 30 vollständig aus dem Zylinderraum der Kolbenzylindereinheit 10 ausgefahren ist.

Sobald die Wellenlänge der Signale in der Größenordnung der Leitungslänge liegt, reicht das vereinfachte Modell der Figur 4b nicht aus. Aus diesem Grund muss bei Wechselspannungen mit hohen Frequenzen auf das Leitungsmodell der Figur 4a ausgewichen werden, um die induktiven und/oder ohmschen Variablen der Leitungslänge der Kolbenzylindereinheit 10 hinreichend genau beschreiben zu können. Insbesondere finden in Figur 4a die Leitungsbeläge zur Beschreibung der Leitungseigenschaften Berücksichtigung, die sich in den Induktivitätsbelag Lₓ, den Widerstandsbelag Rₓ, den Ableitungsbelag G₁ sowie den Kapazitätsbelag C₁ unterteilen lassen. All diese dargestellten Größen sind abhängig von der eingestellten Leitungslänge bzw. der Kolbenposition.

Neben der Verwendung einer Messbrücke als Auswerteeinheit können die induktiven und/oder ohmschen Variablen der Kolbenzylindereinheit auch über die Erfassung der externen Resonanz als auch durch Messung der Impulsantwort der Kolbenzylindereinheit 10 bestimmt werden. Bei einer auf Wechselspannung basierten Auswertung ist der Frequenzbereich zudem einstellbar, wodurch je nach Verfahren auf die oftmals notwendige Abschirmung verzichtet werden kann.

Bei einer Auswertung mit Gleichspannungs- bzw. Wechselspannungssignalen ist das Auswerteverfahren zudem unabhängig von dem verwendeten Hydraulikmedium. Folglich haben Ölalterung, Verschmutzung und eventuelle Temperatureinflüsse keinen oder nur sehr geringen Einfluss auf die Messgenauigkeit.

Weiterhin hält sich der Aufwand für die Integration der Positionsmessvorrichtung in bestehende Zylindereinheiten 10 in Grenzen. Dies wirkt sich nicht nur positiv auf die anfallenden Produktionskosten aus, sondern verringert zudem den notwendigen Wartungsaufwand. Ferner existieren keine Baugrößenbeschränkungen für die Anwendung des Verfahrens. Das vorgestellte Verfahren kann in nahezu jeden beliebigen Arbeitszylinder implementiert werden.

## Patentansprüche

1. Verfahren zur Bestimmung der Kolbenposition einer hydraulischen oder pneumatischen Kolbenzylindereinheit (10), mit einem Zylindermantel (20), in dessen Hohlraum ein Zylinderkolben (40) mit einer Kolbenstange (30) linear verschiebbar gelagert ist, wobei der Zylindermantel (20), der Zylinderkolben (40) sowie die Kolbenstange (30) zusammen einen elektrischen Leitungsweg bilden, und wobei Zylinderkolben (40) und Zylindermantel (20) leitend miteinander verbunden und Kolbenstange (30) und Zylindermantel (20) gegeneinander isoliert sind,
**dadurch gekennzeichnet, dass**
die Kolbenposition anhand der induktiven und/oder ohmschen Eigenschaften des von Zylindermantel (20), Zylinderkolben (40) und Kolbenstange (30) zusammen gebildeten Leitungswegs bestimmt wird, wobei sowohl der Leitungsweg des Zylindermantels (20) als auch der Leitungsweg der Kolbenstange (30) von der Kolbenposition abhängt.

2. Verfahren nach Anspruch 1, **dadurch gekennzeichnet, dass** die Bestimmung der induktiven und/oder ohmschen Eigenschaften durch ein auf Wechselspannung und/oder Gleichspannung basierendes Auswerteverfahren erfolgt, wobei die Frequenz der Wechselspannung vorzugsweise variabel ist.

3. Verfahren nach einem der vorhergehenden Ansprüche, **dadurch gekennzeichnet, dass** die Bestimmung der induktiven und/oder ohmschen Eigenschaften durch Messung der externen Resonanz und/oder der Impulsantwort und/oder unter Verwendung einer Messbrücke erfolgt.

4. Hydraulische oder pneumatische Kolbenzylindereinheit (10) mit einer Vorrichtung zur Bestimmung der Kolbenposition, mit einem Zylindermantel (20), in dessen Hohlraum ein Zylinderkolben (40) mit einer Kolbenstange (30) linear verschiebbar gelagert ist, wobei der Zylindermantel (20), der Zylinderkolben (40) sowie die Kolbenstange (30) zusammen einen elektrischen Leitungsweg bilden, und wobei Zylinderkolben (40) und Zylindermantel (20) leitend miteinander verbunden und Kolbenstange (30) und Zylindermantel (20) gegeneinander isoliert sind, **dadurch gekennzeichnet, dass** die Vorrichtung zur Bestimmung der Kolbenposition eine Auswerteeinheit aufweist, die die Kolbenposition anhand der induktiven und/oder ohmschen Eigenschaften des von Zylindermantel (20), Zylinderkolben (40) und Kolbenstange (30) zusammen gebildeten Leitungswegs bestimmt, wobei die Auswerteeinheit mit dem Kolben (40) und dem Zylindermantel (20) elektrisch leitend in Verbindung steht und mit der Kolbenstange (30) gleitend innerhalb oder außerhalb des Zylindermantels (20) elektrisch leitend verbunden ist, insbesondere mittels Schleifkontakt (120, 130), so dass sowohl der Leitungsweg des Zylindermantels (20) als auch der Leitungsweg der Kolbenstange (30) von der Kolbenposition abhängt.

5. Kolbenzylindereinheit (10) nach Anspruch 4, **dadurch gekennzeichnet, dass** zwischen Kolben (40) und Zylindermantel (20) ein elektrisch leitender Kolbenring (50) oder ein Schleifkontakt vorgesehen ist.

6. Kolbenzylindereinheit (10) nach einem der Ansprüche 4 bis 5, **dadurch gekennzeichnet, dass** die Auswerteeinheit Mittel zur Durchführung eines auf Wechselspannung bzw. Gleichspannung basierendes Auswerteverfahrens zur Bestimmung der induktiven und/oder ohmschen Eigenschaften der Kolbenzylindereinheit (10) umfasst.

7. Kolbenzylindereinheit nach Anspruch 6, **dadurch gekennzeichnet, dass** die Auswerteeinheit eine Messbrücke und/oder Mittel zur Bestimmung der externer Resonanz und/oder der Impulsantwort der Kolbenzylindereinheit (10) umfasst.

8. Baumaschine oder Hubgerät mit einer Kolbenzylindereinheit (10) nach einem der Ansprüche 4 bis 7.

## Claims

1. Method for determining the piston position of a hydraulic or pneumatic piston cylinder unit (10), with a cylinder jacket (20), in the hollow space of which a cylinder piston (40) with a piston rod (30) is mounted in a linear displaceable manner, wherein the cylinder jacket (20), the cylinder piston (40) as well as the piston rod (30) together form an electric line path, and wherein cylinder piston (40) and cylinder jacket (20) are connected to one another in a conductive manner, and piston rod (30) and cylinder jacket (20) are isolated against one another,
**characterized in that**
the piston position is determined based upon the inductive and/or ohmic properties of the line path formed together by the cylinder jacket (20), cylinder piston (40) and piston rod (30), wherein the line path of the cylinder jacket (20) as well as the line path of the piston rod (30) depends upon the piston position.

2. Method according to claim 1, **characterized in that** the determination of the inductive and/or ohmic properties occurs through an evaluation process on the basis of an AC voltage and/or DC voltage, wherein the frequency of the AC voltage preferably is variable.

3. Method according to any one of the preceding claims, **characterized in that** the determination of the inductive and/or ohmic properties occurs through measuring the external resonance and/or the pulse response and/or by use of a measuring bridge.

4. Hydraulic or pneumatic piston cylinder unit (10) with a device for determining the piston position, with a cylinder jacket (20), in the hollow space of which a cylinder piston (40) with a piston rod (30) is mounted in a linearly-displaceable manner, wherein the cylinder jacket (20), the cylinder piston (40) as well as the piston rod (30) together form an electric line path, and wherein cylinder piston (40) and cylinder jacket (20) are connected to one another in a conductive manner, and piston rod (30) and cylinder jacket (20) are isolated against one another, **characterized in that** the device for determining the piston position comprises an evaluation unit, which determines the piston position based upon the inductive and/or ohmic properties of the line path formed together by the cylinder jacket (20), the cylinder piston (40) and the piston rod (30), wherein the evaluation unit is communicated with the piston (40) and the cylinder jacket (20) in an electrically-conductive manner and is electrically-conductively connected with the piston rod (30) in a sliding manner inside or outside the cylinder jacket (20), in particular by means of a sliding contact (120, 130), so that the line path of the cylinder jacket (20) as well as the line path of the piston rod (30) depends on the piston position.

5. Piston cylinder unit (10) according to claim 4, **characterized in that** an electrically-conductive piston ring (50) or a sliding contact is provided between piston (40) and cylinder jacket (20).

6. Piston cylinder unit (10) according to any of claims 4 to 5, **characterized in that** the evaluation unit comprises means for performing an evaluation process on the basis of AC voltage or DC voltage for the determination of the inductive and/or ohmic properties of the piston cylinder unit (10).

7. Piston cylinder unit according to claim 6, **characterized in that** the evaluation unit comprises a measuring bridge and/or means for determining the external resonance and/or the pulse response of the piston cylinder unit (10).

8. Construction or hoisting apparatus with a piston cylinder unit (10) in accordance with any one of claims 4 to 7.

## Revendications

1. Procédé servant à définir la position de piston d'une unité piston-cylindre (10) hydraulique ou pneumatique, avec une enveloppe de cylindre (20) dans l'espace creux de laquelle un piston de cylindre (40) pourvu d'une tige de piston (30) est monté de manière à pouvoir coulisser linéairement, dans lequel l'enveloppe de cylindre (20), le piston de cylindre (40) ainsi que la tige de piston (30) forment conjointement une voie de conduction électrique, et dans lequel le piston de cylindre (40) et l'enveloppe de cylindre (20) sont reliés l'un à l'autre de manière conductrice et la tige de piston (30) et l'enveloppe de cylindre (20) sont isolées l'une de l'autre,
**caractérisé en ce que**
la position de piston est définie à l'aide des propriétés inductives et/ou ohmiques de la voie de conduction formée conjointement par l'enveloppe de cylindre (20), le piston de cylindre (40) et la tige de piston (30), dans lequel à la fois la voie de conduction de l'enveloppe de cylindre (20) et la voie de conduction de la tige de piston (30) dépendent de la position de piston.

2. Procédé selon la revendication 1, **caractérisé en ce que** la définition des propriétés inductives et/ou ohmiques est effectuée par un procédé d'évaluation se basant sur la tension alternative et/ou la tension continue, dans lequel la fréquence de la tension alternative est de préférence variable.

3. Procédé selon l'une quelconque des revendications précédentes, **caractérisé en ce que** la définition des propriétés inductives et/ou ohmiques est effectuée par la mesure de la résonance externe et/ou de la réponse impulsionnelle et/ou en utilisant un pont de mesure.

4. Unité piston-cylindre (10) hydraulique ou pneumatique avec un dispositif servant à définir la position de piston, avec une enveloppe de cylindre (20), dans l'espace creux de laquelle un piston de cylindre (40) pourvu d'une tige de piston (30) est disposé de manière à pouvoir être coulissé linéairement, dans laquelle l'enveloppe de cylindre (20), le piston de cylindre (40) ainsi que la tige de piston (30) forment conjointement une voie de conduction électrique, et dans laquelle le piston de cylindre (40) et l'enveloppe de cylindre (20) sont reliés l'un à l'autre de manière conductrice et la tige de piston (30) et l'enveloppe de cylindre (20) sont isolées l'une par rapport à l'autre, **caractérisée en ce que** le dispositif servant à définir la position de piston présente une unité d'évaluation, qui définit la position de piston à l'aide des propriétés inductives et/ou ohmiques de la voie de conduction formée conjointement par l'enveloppe de cylindre (20), le piston de cylindre (40) et la tige de piston (30), dans laquelle l'unité d'évaluation se trouve en liaison électroconductrice avec le piston (40) et l'enveloppe de cylindre (20) et est reliée de manière électroconductrice à la tige de piston (30) de manière coulissante à l'intérieur ou à l'extérieur de l'enveloppe de cylindre (20), en particulier au moyen d'un contact à frottement (120, 130) de sorte qu'à la fois la voie de conduction de l'enveloppe de cylindre (20) et la voie de conduction de la tige de piston (30) dépendent de la position de piston.

5. Unité piston-cylindre (10) selon la revendication 4, **caractérisée en ce qu'**une bague de piston (50) électroconductrice ou un contact à frottement est prévue ou prévu entre le piston (40) et l'enveloppe de cylindre (20).

6. Unité piston-cylindre (10) selon l'une quelconque des revendications 4 à 5, **caractérisée en ce que** l'unité d'évaluation comprend des moyens servant à mettre en oeuvre un procédé d'évaluation se basant sur la tension alternative ou la tension continue, servant à définir les propriétés inductives et/ou ohmiques de l'unité piston-cylindre (10).

7. Unité piston-cylindre selon la revendication 6, **caractérisée en ce que** l'unité d'évaluation comprend un pont de mesure et/ou des moyens servant à définir la résonance externe et/ou la réponse impulsionnelle de l'unité piston-cylindre (10).

8. Engin de construction ou appareil de levage avec une unité piston-cylindre (10) selon l'une quelconque des revendications 4 à 7.
